(19) Europäisches Patentamt
European Patent Office
Office européen des brevets

(11) **EP 3 951 496 A1**

(12) **EUROPEAN PATENT APPLICATION**

(43) Date of publication:
**09.02.2022 Bulletin 2022/06**

(21) Application number: **20189955.6**

(22) Date of filing: **07.08.2020**

(51) International Patent Classification (IPC):
**G03F 1/36** (2012.01)   **G03F 1/70** (2012.01)
**G03F 7/20** (2006.01)   **G06F 30/398** (2020.01)
**G06N 20/00** (2019.01)   **G06T 7/00** (2017.01)

(52) Cooperative Patent Classification (CPC):
**G03F 1/36; G03F 1/70; G03F 7/70441;**
**G03F 7/705; G06F 30/398; G06N 20/00;**
**G06T 7/001**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(71) Applicant: **ASML Netherlands B.V.**
**5500 AH Veldhoven (NL)**

(72) Inventors:
• **PISARENCO, Maxim**
**5500 AH Veldhoven (NL)**
• **MIDDLEBROOKS, Scott, Anderson**
**5500 AH Veldhoven (NL)**
• **VAN KRAAIJ, Markus, Gerardus, Martinus, Maria**
**5500 AH Veldhoven (NL)**
• **VERSCHUREN, Coen, Adrianus**
**5500 AH Veldhoven (NL)**

(74) Representative: **ASML Netherlands B.V.**
**Corporate Intellectual Property**
**P.O. Box 324**
**5500 AH Veldhoven (NL)**

(54) **APPARATUS AND METHOD FOR SELECTING INFORMATIVE PATTERNS FOR TRAINING MACHINE LEARNING MODELS**

(57)   Described herein is a method and apparatus for selecting patterns from an image such as a design layout. The method includes obtaining an image (e.g., of a target layout) having a plurality of patterns; determining, based on pixel intensities within the image, a metric (e.g., entropy) indicative of an amount of information contained in one or more portions of the image; and selecting, based on the metric, a sub-set of the plurality of patterns from the one or more portions of the image having values of the metric within a specified range. The sub-set of patterns can be provided as training data for training a model associated with a patterning process.

**FIG. 3A**

**Description**

**TECHNICAL FIELD**

The description herein relates generally to improving lithography and related processes. More particularly, apparatuses, methods, and computer program products for selecting informative patterns for training models used in lithography or related process.

**BACKGROUND**

A lithographic projection apparatus can be used, for example, in the manufacture of integrated circuits (ICs). In such a case, a patterning device (e.g., a mask) may contain or provide a pattern corresponding to an individual layer of the IC ("design layout"), and this pattern can be transferred onto a target portion (e.g. comprising one or more dies) on a substrate (e.g., silicon wafer) that has been coated with a layer of radiation-sensitive material ("resist"), by methods such as irradiating the target portion through the pattern on the patterning device. In general, a single substrate contains a plurality of adjacent target portions to which the pattern is transferred successively by the lithographic projection apparatus, one target portion at a time. In one type of lithographic projection apparatuses, the pattern on the entire patterning device is transferred onto one target portion in one go; such an apparatus is commonly referred to as a stepper. In an alternative apparatus, commonly referred to as a step-and-scan apparatus, a projection beam scans over the patterning device in a given reference direction (the "scanning" direction) while synchronously moving the substrate parallel or anti-parallel to this reference direction. Different portions of the pattern on the patterning device are transferred to one target portion progressively. Since, in general, the lithographic projection apparatus will have a reduction ratio M (e.g., 4), the speed F at which the substrate is moved will be 1/M times that at which the projection beam scans the patterning device. More information with regard to lithographic devices can be found in, for example, US 6,046,792, incorporated herein by reference.

Prior to transferring the pattern from the patterning device to the substrate, the substrate may undergo various procedures, such as priming, resist coating and a soft bake. After exposure, the substrate may be subjected to other procedures ("post-exposure procedures"), such as a post-exposure bake (PEB), development, a hard bake and measurement/inspection of the transferred pattern. This array of procedures is used as a basis to make an individual layer of a device, e.g., an IC. The substrate may then undergo various processes such as etching, ion-implantation (doping), metallization, oxidation, chemo-mechanical polishing, etc., all intended to finish off the individual layer of the device. If several layers are required in the device, then the whole procedure, or a variant thereof, is repeated for each layer. Eventually, a device will be present in each target portion on the substrate. These devices are then separated from one another by a technique such as dicing or sawing, whence the individual devices can be mounted on a carrier, connected to pins, etc.

Thus, manufacturing devices, such as semiconductor devices, typically involve processing a substrate (e.g., a semiconductor wafer) using a number of fabrication processes to form various features and multiple layers of the devices. Such layers and features are typically manufactured and processed using, e.g., deposition, lithography, etch, chemical-mechanical polishing, and ion implantation. Multiple devices may be fabricated on a plurality of dies on a substrate and then separated into individual devices. This device manufacturing process may be considered a patterning process. A patterning process involves a patterning step, such as optical and/or nanoimprint lithography using a patterning device in a lithographic apparatus, to transfer a pattern on the patterning device to a substrate and typically, but optionally, involves one or more related pattern processing steps, such as resist development by a development apparatus, baking of the substrate using a bake tool, etching using the pattern using an etch apparatus, etc.

**SUMMARY**

In an embodiment, there is provided a method for generating training data for machine learning models. The training data is selected based on an information metric (e.g., information entropy) associated with target patterns within a target layout. The target layout can have hundreds of millions patterns, as such selection of most informative patterns for training purposes is desired. In an embodiment, the information metric enables selection of patterns without executing additional patterning related process models or machine learning models. As such, selection can be applied directly to the target layout that can also save a lot of computational resources and time.

In an embodiment, the method includes obtaining an image comprising a first pattern and a second pattern; determining, based on pixel intensities of the first pattern, a first level of informational entropy in a first portion of the image; determining, based on pixel intensities of the second pattern, a second level of informational entropy in a second portion of the image; comparing the first level of informational entropy and the second level of informational entropy; determining that the first level of informational entropy is lower than the second level of informational entropy based on the comparison; and in response to determining that the first level of informational entropy is lower than the second level of informational entropy, generating a training data set comprising the first pattern or at least a portion of the first pattern.

In an embodiment, the method includes obtaining an image (e.g., a target layout) having a plurality of patterns (e.g., target patterns); determining, based on pixel intensities within the image, a metric indicative of an amount of information contained in one or more portions of the image; selecting, based on the metric, a sub-set of the plurality of patterns from the one or more portions of the image having values of the metric within a specified range. The selected sub-set of patterns can be provided the sub-set of patterns as training data for training a model (e.g., OPC) associated with a patterning process. For example, the metric can information entropy calculated based on probabilities associated with pixels within a window overlaid on the image.

In an embodiment, the metric is indicative of non-homogeneity of each of the plurality of patterns, an uncertainty associated with a model prediction, or an error associated with a model prediction. Hence, the metric can guide the selection of most informative patterns from, hundreds of millions of patterns from a target layout, for example.

According to an embodiment, there is provided a computer system comprising a non-transitory computer readable medium having instructions recorded thereon. The instructions, when executed by a computer, implement the method steps above.

## BRIEF DESCRIPTION OF THE DRAWINGS

The accompanying drawings, which are incorporated in and constitute a part of this specification, show certain aspects of the subject matter disclosed herein and, together with the description, help explain some of the principles associated with the disclosed embodiments. In the drawings,

Figure 1 illustrates a block diagram of various subsystems of a lithographic projection apparatus, according to an embodiment.

Figure 2 illustrates an exemplary flow chart for simulating lithography in a lithographic projection apparatus, according to an embodiment.

Figure 3A shows a comparison of different methods used for selecting patterns from a target layout, according to an embodiment.

Figure 3B is an enlarged version of an error-based method shown in Figure 3A, according to an embodiment.

Figure 3C is an enlarged version of an uncertainty-based method shown in Figure 3A, according to an embodiment.

Figure 3D is an enlarged version of a method using exemplary metric (e.g., entropy) to select patterns from the target layout, according to an embodiment.

Figure 3E visually depicts a correlation between entropy and errors associated with the target layout, according to an embodiment.

Figure 3F visually depicts a correlation between entropy and uncertainty associated with the target layout, according to an embodiment.

Figure 4 is a flowchart of a method for selecting patterns from a target layout based on an information content metric, according to an embodiment.

Figure 5 is a block diagram of an example computer system, according to an embodiment.

Figure 6 is a schematic diagram of a lithographic projection apparatus, according to an embodiment.

Figure 7 is a schematic diagram of another lithographic projection apparatus, according to an embodiment.

Figure 8 is a detailed view of the lithographic projection apparatus, according to an embodiment.

Figure 9 is a detailed view of the source collector module of the lithographic projection apparatus, according to an embodiment.

## DETAILED DESCRIPTION

Although specific reference may be made in this text to the manufacture of ICs, it should be explicitly understood that the description herein has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as interchangeable with the more general terms "mask", "substrate" and "target portion", respectively.

In the present document, the terms "radiation" and "beam" may be used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The patterning device can comprise, or can form, one or more design layouts. The design layout can be generated utilizing CAD (computer-aided design) programs, this process often being referred to as EDA (electronic design automation). Most CAD programs follow a set of predetermined design rules in order to create functional design layouts/patterning devices. These rules are set by processing and design limitations. For example, design rules define the space tolerance between devices (such as gates, capacitors, etc.) or interconnect lines, so as to ensure that the devices or lines do not interact with one another in an undesirable way. One or more of the design rule limitations may be referred to as "critical dimension" (CD). A critical dimension of a device can be defined as the smallest width of a line or hole or the smallest space between two lines or two holes. Thus, the CD determines the overall size and density of the designed device. Of course, one of the goals in device fabrication is to faithfully reproduce the original design intent on the substrate (via the patterning device).

The term "mask" or "patterning device" as employed in this text may be broadly interpreted as referring to a generic patterning device that can be used to endow an incoming radiation beam with a patterned cross-section, corresponding to a pattern that is to be created in a target portion of the substrate; the term "light valve" can also be used in this context. Besides the classic mask (transmissive or reflective; binary, phase-shifting, hybrid, etc.), examples of other such patterning devices include a programmable mirror array and a programmable LCD array.

An example of a programmable mirror array can be a matrix-addressable surface having a viscoelastic control layer and a reflective surface. The basic principle behind such an apparatus is that (for example) addressed areas of the reflective surface reflect incident radiation as diffracted radiation, whereas unaddressed areas reflect incident radiation as undiffracted radiation. Using an appropriate filter, the said undiffracted radiation can be filtered out of the reflected beam, leaving only the diffracted radiation behind; in this manner, the beam becomes patterned according to the addressing pattern of the matrix-addressable surface. The required matrix addressing can be performed using suitable electronic means.

An example of a programmable LCD array is given in U.S. Patent No. 5,229,872, which is incorporated herein by reference.

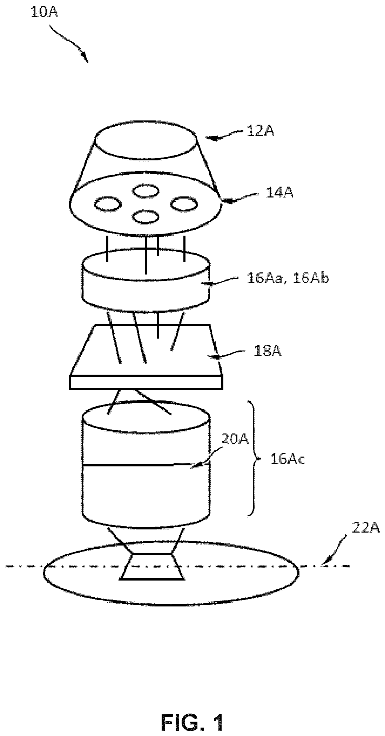

Figure 1 illustrates a block diagram of various subsystems of a lithographic projection apparatus 10A, according to an embodiment. Major components are a radiation source 12A, which may be a deep-ultraviolet excimer laser source or other type of source including an extreme ultra violet (EUV) source (as discussed above, the lithographic projection apparatus itself need not have the radiation source), illumination optics which, e.g., define the partial coherence (denoted as sigma) and which may include optics 14A, 16Aa and 16Ab that shape radiation from the source 12A; a patterning device 18A; and transmission optics 16Ac that project an image of the patterning device pattern onto a substrate plane 22A. An adjustable filter or aperture 20A at the pupil plane of the projection optics may restrict the range of beam angles that impinge on the substrate plane 22A, where the largest possible angle defines the numerical aperture of the projection optics NA= n sin($\Theta_{max}$), wherein n is the refractive index of the media between the substrate and the last element of the projection optics, and $\Theta_{max}$ is the largest angle of the beam exiting from the projection optics that can still impinge on the substrate plane 22A.

In a lithographic projection apparatus, a source provides illumination (i.e. radiation) to a patterning device and projection optics direct and shape the illumination, via the patterning device, onto a substrate. The projection optics may include at least some of the components 14A, 16Aa, 16Ab and 16Ac. An aerial image (AI) is the radiation intensity distribution at substrate level. A resist model can be used to calculate the resist image from the aerial image, an example of which can be found in U.S. Patent Application Publication No. US 2009-0157630, the disclosure of which is hereby incorporated by reference in its entirety. The resist model is related only to properties of the resist layer (e.g., effects of chemical processes which occur during exposure, post-exposure bake (PEB) and development). Optical properties of the lithographic projection apparatus (e.g., properties of the illumination, the patterning device and the projection optics) dictate the aerial image and can be defined in an optical model. Since the patterning device used in the lithographic projection apparatus can be changed, it is desirable to separate the optical properties of the patterning device from the optical properties of the rest of the lithographic projection apparatus including at least the source and the projection optics. Details of techniques and models used to transform a design layout into various lithographic images (e.g., an aerial image, a resist image, etc.), apply OPC using those techniques and models and evaluate performance (e.g., in terms of process window) are described in U.S. Patent Application Publication Nos. US 2008-0301620, 2007-0050749, 2007-0031745, 2008-0309897, 2010-0162197, and 2010-0180251, the disclosure of each which is hereby incorporated by reference in its entirety.

According to an embodiment of the present disclosure, one or more images may be generated. The images includes various types of signal that may be characterized by pixel values or intensity values of each pixel. Depending on the relative values of the pixel within the image, the signal may be referred as, for example, a weak signal or a strong signal, as may be understood by a person of ordinary skill in the art. The term "strong" and "weak" are relative terms based on intensity values of pixels within an image and specific values of intensity may not limit scope of the present disclosure. In an embodiment, the strong and weak signal may be identified based on a selected threshold value. In an embodiment, the threshold value may be fixed (e.g., a midpoint of a highest intensity and a lowest intensity of pixel within the image. In an embodiment, a strong signal may refer to a signal with values greater than or equal to an average signal value across the image and a weak signal may refer to signal with values less than the average signal value. In an embodiment, the relative intensity value may be based on percentage. For example, the weak signal may be signal having intensity less than 50% of the highest intensity of the pixel (e.g., pixels corresponding to target pattern may be considered pixels with highest intensity) within the image. Furthermore, each pixel within an image may considered as a variable. According to the present embodiment, derivatives or partial derivative may be determined with respect to each pixel within the image and the values of each pixel may be determined or modified according to a cost function based evaluation and/or gradient based computation of the cost function. For example, a CTM image may include pixels, where each pixel is a variable that can take any real value.

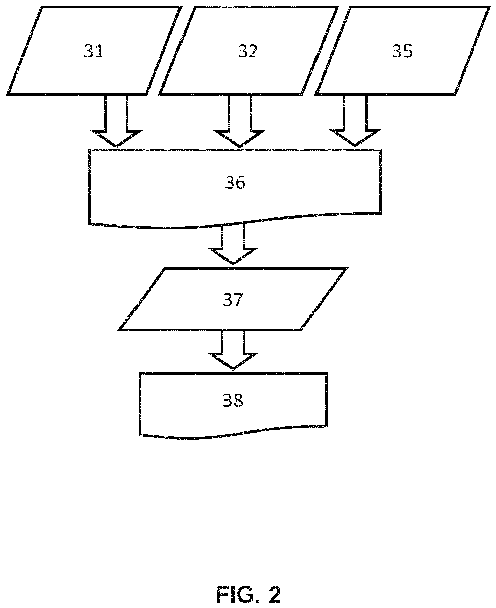

Figure 2 illustrates an exemplary flow chart for simulating lithography in a lithographic projection apparatus, according to an embodiment. Source model 31 represents optical characteristics (including radiation intensity distribution and/or phase distribution) of the source. Projection optics model 32 represents optical characteristics (including changes to the radiation intensity distribution and/or the phase distribution caused by the projection optics) of the projection optics. Design layout model 35 represents optical characteristics of a design layout (including changes to the radiation intensity distribution and/or the phase distribution caused by design layout 33), which is the representation of an arrangement of features on or formed by a patterning device. Aerial image 36 can be simulated from design layout model 35, projection optics model 32, and design layout model 35. Resist image 38 can be simulated from aerial image 36 using resist model 37. Simulation of lithography can, for example, predict contours and CDs in the resist image.

More specifically, it is noted that source model 31 can represent the optical characteristics of the source that include, but not limited to, numerical aperture settings, illumination sigma ($\sigma$) settings as well as any particular illumination shape (e.g. off-axis radiation sources such as annular, quadrupole, dipole, etc.). Projection optics model 32 can represent the optical characteristics of the projection optics, including aberration, distortion, one or more refractive indexes, one or more physical sizes, one or more physical dimensions, etc. Design layout model 35 can represent one or more physical properties of a physical patterning device, as described, for example, in U.S. Patent No. 7,587,704, which is incorporated by reference in its entirety. The objective of the simulation is to accurately predict, for example, edge placement, aerial image intensity slope and/or CD, which can then be compared against an intended design. The intended design is generally defined as a pre-OPC design layout which can be provided in a standardized digital file format such as GDSII or OASIS or other file format.

From this design layout, one or more portions may be identified, which are referred to as "clips". In an embodiment, a set of clips is extracted, which represents the complicated patterns in the design layout (typically about 50 to 1000 clips, although any number of clips may be used). These patterns or clips represent small portions (i.e. circuits, cells or patterns) of the design and more specifically, the clips typically represent small portions for which particular attention and/or verification is needed. In other words, clips may be the portions of the design layout, or may be similar or have a similar behavior of portions of the design layout, where one or more critical features are identified either by experience (including clips provided by a customer), by trial and error, or by running a full-chip simulation. Clips may contain one or more test patterns or gauge patterns.

An initial larger set of clips may be provided a priori by a customer based on one or more known critical feature areas in a design layout which require particular image optimization. Alternatively, in another embodiment, an initial larger set of clips may be extracted from the entire design layout by using some kind of automated (such as machine vision) or manual algorithm that identifies the one or more critical feature areas.

In a lithographic projection apparatus, as an example, a cost function may be expressed as

$$CF(z_1, z_2, \cdots, z_N) = \sum_{p=1}^{P} w_p f_p^2(z_1, z_2, \cdots, z_N) \qquad \text{(Eq. 1)}$$

where $(z_1, z_2, \cdots, z_N)$ are N design variables or values thereof. $f_p(z_1, z_2, \cdots, z_N)$ can be a function of the design variables $(z_1, z_2, \cdots, z_N)$ such as a difference between an actual value and an intended value of a characteristic for a set of values of the design variables of $(z_1, z_2, \cdots, z_N)$. $w_p$ is a weight constant associated with $f_p(z_1, z_2, \cdots, z_N)$. For example, the characteristic may be a position of an edge of a pattern, measured at a given point on the edge. Different $f_p(z_1, z_2, \cdots, z_N)$ may have different weight $w_p$. For example, if a particular edge has a narrow range of permitted positions, the weight $w_p$ for the $f_p(z_1, z_2, \cdots, z_N)$ representing the difference between the actual position and the intended position of the edge may be given a higher value. $f_p(z_1, z_2, \cdots, z_N)$ can also be a function of an interlayer characteristic, which is in turn a function of the design variables $(z_1, z_2, \cdots, z_N)$. Of course, $CF(z_1, z_2, \cdots, z_N)$ is not limited to the form in Eq. 1. $CF(z_1, z_2, \cdots, z_N)$ can be in any other suitable form.

The cost function may represent any one or more suitable characteristics of the lithographic projection apparatus, lithographic process or the substrate, for instance, focus, CD, image shift, image distortion, image rotation, stochastic variation, throughput, local CD variation, process window, an interlayer characteristic, or a combination thereof. In one embodiment, the design variables $(z_1, z_2, \cdots, z_N)$ comprise one or more selected from dose, global bias of the patterning device, and/or shape of illumination. Since it is the resist image that often dictates the pattern on a substrate, the cost function may include a function that represents one or more characteristics of the resist image. For example, $f_p(z_1, z_2, \cdots, z_N)$

can be simply a distance between a point in the resist image to an intended position of that point (i.e., edge placement error $EPE_p(z_1,z_2,\cdots,z_N)$. The design variables can include any adjustable parameter such as an adjustable parameter of the source, the patterning device, the projection optics, dose, focus, etc.

The lithographic apparatus may include components collectively called a "wavefront manipulator" that can be used to adjust the shape of a wavefront and intensity distribution and/or phase shift of a radiation beam. In an embodiment, the lithographic apparatus can adjust a wavefront and intensity distribution at any location along an optical path of the lithographic projection apparatus, such as before the patterning device, near a pupil plane, near an image plane, and/or near a focal plane. The wavefront manipulator can be used to correct or compensate for certain distortions of the wavefront and intensity distribution and/or phase shift caused by, for example, the source, the patterning device, temperature variation in the lithographic projection apparatus, thermal expansion of components of the lithographic projection apparatus, etc. Adjusting the wavefront and intensity distribution and/or phase shift can change values of the characteristics represented by the cost function. Such changes can be simulated from a model or actually measured. The design variables can include parameters of the wavefront manipulator.

The design variables may have constraints, which can be expressed as $(z_1,z_2,\cdots,z_N) \in Z$, where $Z$ is a set of possible values of the design variables. One possible constraint on the design variables may be imposed by a desired throughput of the lithographic projection apparatus. Without such a constraint imposed by the desired throughput, the optimization may yield a set of values of the design variables that are unrealistic. For example, if the dose is a design variable, without such a constraint, the optimization may yield a dose value that makes the throughput economically impossible. However, the usefulness of constraints should not be interpreted as a necessity. For example, the throughput may be affected by the pupil fill ratio. For some illumination designs, a low pupil fill ratio may discard radiation, leading to lower throughput. Throughput may also be affected by the resist chemistry. Slower resist (e.g., a resist that requires higher amount of radiation to be properly exposed) leads to lower throughput.

As used herein, the term "patterning process" generally means a process that creates an etched substrate by the application of specified patterns of light as part of a lithography process. However, "patterning process" can also include plasma etching, as many of the features described herein can provide benefits to forming printed patterns using plasma processing.

As used herein, the term "target pattern" means an idealized pattern that is to be etched on a substrate. The term "target layout" refers to a design layout comprising one or more target patterns.

As used herein, the term "printed pattern" or "patterned substrate" means the physical pattern on a substrate that was imaged and/or etched based on a target pattern. The printed pattern can include, for example, troughs, channels, depressions, edges, or other two and three dimensional features resulting from a lithography process.

As used herein, the term "process model" means a model that includes one or more models that simulate a patterning process. For example, a process model can include an optical model (e.g., that models a lens system/projection system used to deliver light in a lithography process and may include modelling the final optical image of light that goes onto a photoresist), a resist model (e.g., that models physical effects of the resist, such as chemical effects due to the light), and an OPC model (e.g., that can be used to modify target patterns to include sub-resolution resist features (SRAFs), etc.).

In order to improve the patterning process and patterning accuracy, process models are trained using target patterns, mask patterns, substrate images, etc. For example, the process model comprises one or more trained models used in OPC process to generate better mask patterns. For example, OPC assisted by machine learning significantly improves the accuracy of full chip assist feature (e.g., SRAF) placement while keeping consistency and runtime of the mask design under control. A deep convolutional neural network (CNN) is trained using the target layout or target patterns therein, and corresponding continuous transmission mask (CTM) images. These CTM images are optimized using an inverse mask optimization simulation process. The CNN generated SRAF guidance map is then used to place SRAF on full-chip design layout.

When choosing a set of patterns for training, it is desired to select patterns that will be most informative for the model. Currently, following approaches are available to measure how informative a pattern is: an error-based approach and an uncertainty-based approach. In the error-based approach, an error is the difference between a model prediction and a ground truth or a reference. The larger the error for a particular pattern, the more informative that pattern is expected to be. In the uncertainty-based approach, a standard deviation of the model prediction e.g., prediction from a Bayesian neural network is used. The larger the uncertainty for a particular pattern, the more informative that pattern is expected to be. Unlike error (e.g., root mean squared error (RMSE)), uncertainty does not require the availability of ground truth.

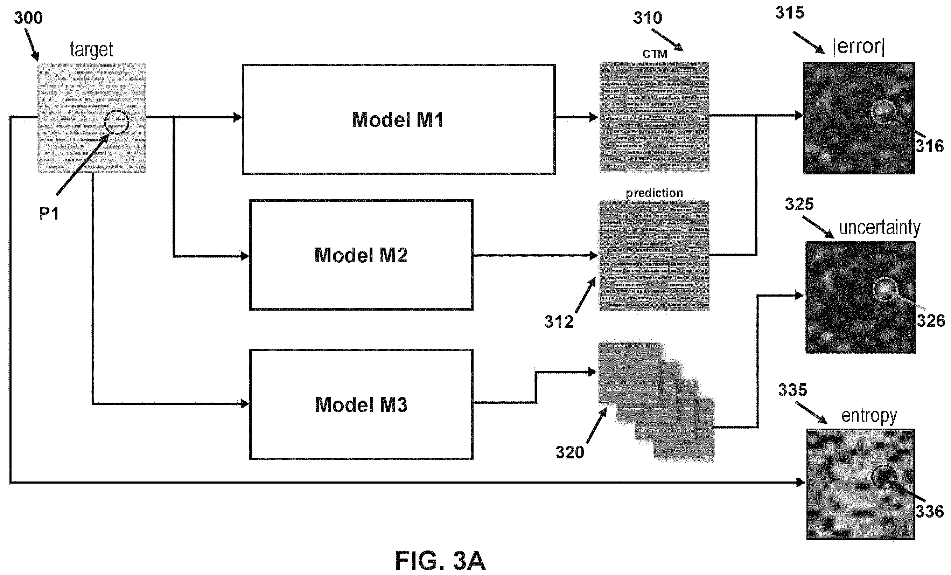

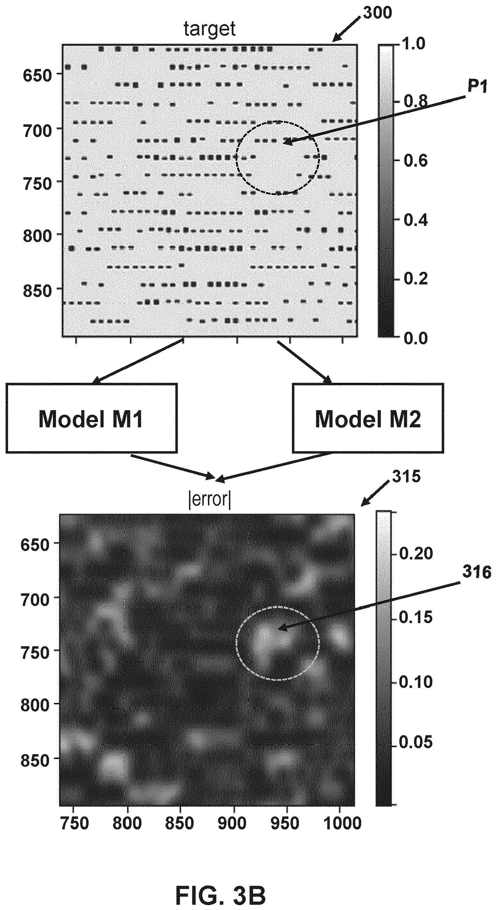

Figure 3A and 3B illustrate an example of an error-based approach used for selecting patterns from a target layout. The error-based approach uses a process model M1 and a machine learning model M2. The process model M1 can be a physics-based models (e.g., as discussed in Figure 2) employed in an inverse lithographic simulation process to generate a CTM image 310 (an example of a ground truth). A model M2 (e.g., CNN) is trained model trained using target and the ground truth CTM images. The model M2 predicts a CTM image 312 using a target layout 300 as input.

An error 315 between the CTM images 310 and 312 is determined. For example, the error can be a difference between the CTM images 310 and 312, RMSE between images 310 and 312, or other errors. The error can be represented as a grey scale image, referred as an error image 315, for example. The error image 315 visually depicts several bright and dark portions corresponding to e.g., high errors and low errors within the error image 315. In an embodiment, patterns or target portions (e.g., portion P1 of image 300) corresponding to high errors (e.g., portion 316 of the error image 315) may be selected as training data for training a model related to a patterning process.

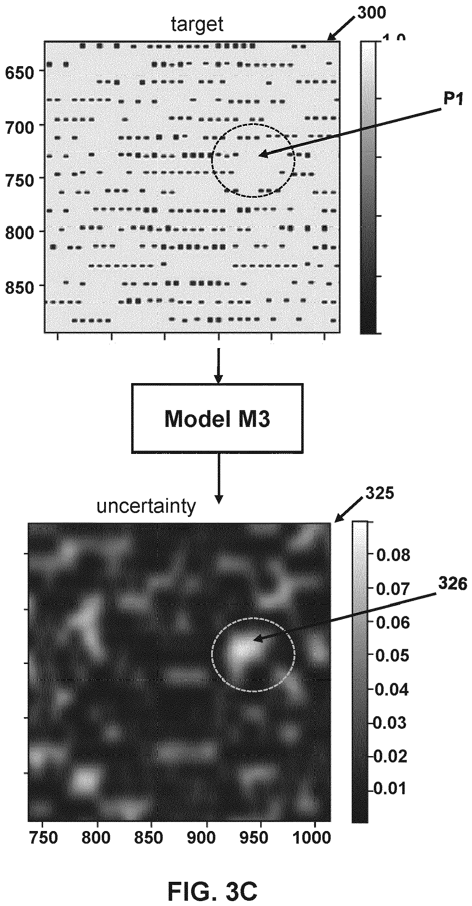

Figure 3A and 3C illustrate an example of an uncertainty-based approach used for selecting patterns from a target layout. The uncertainty-based approach uses a model M3 that generates CTM images 320. An uncertainty (e.g., standard deviation) between CTM images 320 is computed. The uncertainty can be represented as a grey scale image, referred as an uncertainty image 325. The uncertainty image 315 visually depicts several bright and dark portions corresponding to e.g., high uncertainty and low uncertainty within the uncertainty image 325. In an embodiment, patterns or target portions (e.g., portion P1 of image 300) corresponding to high uncertainty (e.g., portion 326 of the error image 325) may be selected as training data for training a model related to a patterning process.

However, the existing approaches have some limitations. For the error-based approach, the ground truth (e.g., CTM 310) is generated e.g., by simulating process model, which is a computationally expensive process. For uncertainty-based approach, multiple forward passes through a neural network are required in order to compute a standard deviation. This is typically faster than the error-based approach, but does leave room for further improvement.

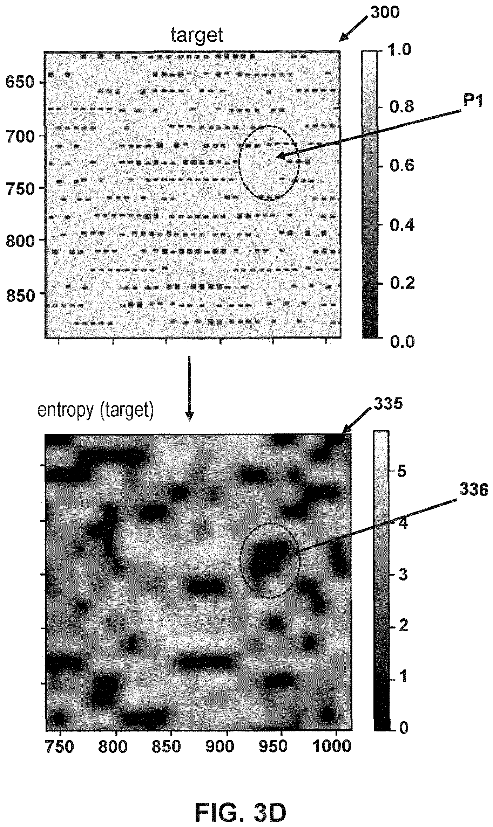

In the present embodiment, referring to Figure 3D, there is provided a method of pattern selection e.g., from a design layout for training a machine learning model. The pattern selection method substantially reduces the need for ground truth data and/or multiple forward passes through the machine learning model. In the present method, an information metric (e.g., information entropy 335 of the target layout 300) is determined that guides the selection of patterns from a target layout. In an embodiment, the information metric serves as a predictor of an error and an uncertainty (e.g., as discussed with respect to Figure 3A). For example, a study revealed that there is a correlation between the information metric, and an error and an uncertainty associated with model predictions.

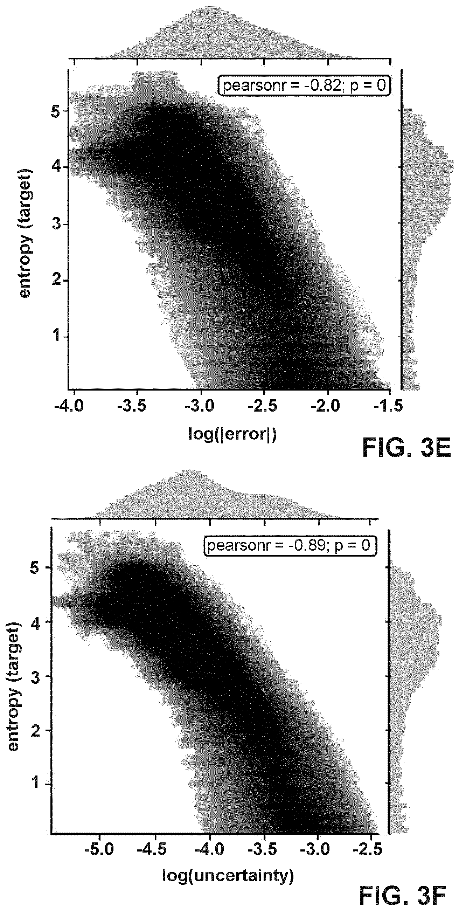

Figures 3E and 3F visually depicts an example correlation between the information metric, and error and uncertainty. For example, as shown in Figure 3E, there is a negative correlation between the information metric (e.g., informational entropy) and errors. In an embodiment, the low entropy values correspond to high errors. Similarly, as shown in Figure 3F, there is a negative correlation between the information metric (e.g., informational entropy) and uncertainty. In an embodiment, the low entropy values correspond to high uncertainty. Thus, in an embodiment, low information entropy regions (e.g., dark portions in image 335 of Figure 3D) may be selected, and patterns or portions (e.g., P1 of target layout 300) may be selected as training data.

According to the present disclosure, determining an information metric such as a local entropy of the target layout, can significantly improve the pattern selection process by saving substantial computation time and resources. For example, according to present disclosure, the need for expensive physics-based computation for generating CTM used in the error-based approach can be completely eliminated. Also, the information metric can help eliminate multiple forward passes of the neural network that may be performed in the uncertainty based approach.

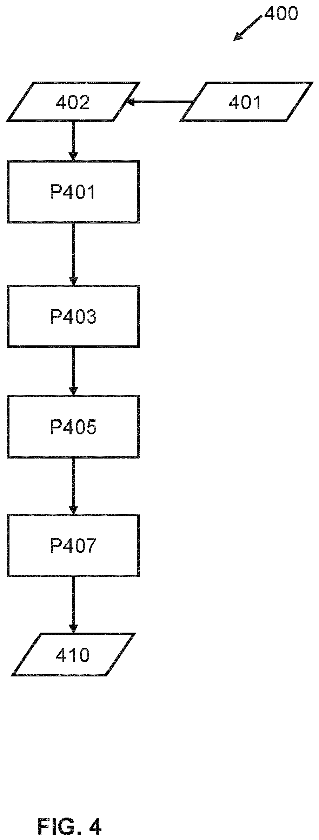

Figure 4 is a flow chart of a method 400 for selecting patterns or portions of the patterns from an input e.g., a target layout including target patterns to be patterning a substrate, according to an embodiment. In an embodiment, the input may be represented in an image format, vector format, or other appropriate electronic formats. The selected patterns can be used as training data for training a model associated with a patterning process. The method involves processes P401, P403, P405 and P407.

Process P401 includes obtaining an image 402 having a plurality of patterns 401. In an embodiment, the image 402 is at least one of: a design layout comprising patterns to be printed on a substrate; or a SEM image of a patterned substrate acquired via a scanning electron microscope (SEM). In an embodiment the image 402 is at least one of: a binary image, a grey scale image; or an n-channel image, where n refers to number of colors used in the image 402 (e.g., 3-channel image with colors red, green and blue (RGB)). For example, a binary image may include pixels assigned value 1 indicating a feature at a pixel location, and value 0 indicating no feature presence at a pixel location. Similarly, the grey scale image may include pixel intensities indicative of presence of absence of a feature of a pattern. In an embodiment, the n-channel image may comprise RGB color channels, which may be indicative of presence or absence of a feature of a pattern. In an embodiment, the color of the RGB can be indicative of a collection of particular features in a pattern.

In an embodiment, a pattern of the plurality of patterns 401 may include one or more features (e.g. line, holes, etc.) desired to be printed on a substrate. In an embodiment, the one or more features are arranged relative to each other according to circuit design specifications. In an embodiment, a pattern of the plurality of patterns 401 includes one or more features (e.g., lines, holes, etc.) printed on a substrate. The present disclosure is not limited to a particular image or patterns, or features therein.

Process P403 includes determining, based on pixel intensities within the image 402, a metric indicative of an amount of information contained in one or more portions of the image 402. In an embodiment, the amount of information is indicative of non-homogeneity of each of the plurality of patterns 401, an uncertainty associated with a model prediction obtained using the plurality of patterns 401, or an error associated with a model prediction obtained using the plurality of patterns 401. For example the non-homogeneity of patterns indicate the patterns are substantially different from each other and hence more informative for training purposes. In an embodiment, the metric is at least one of an information entropy, Renyi entropy, or differential entropy.

In an embodiment, the information entropy comprises a sum of products of a probability of an outcome of a plurality of possible outcomes associated with the image 402 and a logarithmic function of the probability of the outcome. In an embodiment, the information entropy is computed by following equation:

$$H(X) = - \sum_i P_X(x_i) \log P_X(x_i)$$

In the above equation, $H(X)$ is the entropy of the portion of the image within a sliding window overlaid on the image, $x_i$ represents possible outcomes associated with the image 402, each outcome having a probability $P_X(x_i)$. For example, in binary image, the possible outcomes $x_i$, are $x_1$ and $x_2$, where $x_1$ is a white pixel (e.g., pixel intensity value is 0) and $x_2$ is a black pixel (e.g., pixel intensity value is 1). For example, Figure 3A and 3D show a visual depiction of the entropy computed for a target layout represented as a binary image. In an embodiment, the image 402 can be a grey scale image, in which case the possible outcomes $x_i$, wherein can vary from 0 to 255.

For example, the probability $P_X(x_i)$ is computed as follows: $P_X(x_i)$ = (number of pixels with intensity level $i$ in the sliding window) / (number of pixels in the sliding window). The associated entropy value is then typically assigned to a center pixel in the sliding window. So, for the binary image example, the entropy expression is largest if 50% of the pixels are white and 50% are black (i.e. $P_X(x_1)$ = $P_X(x_2)$ = 0.5), whereas it is smallest when only a single color is present in the entire sliding window (i.e. $P_X(x_1)$ = 1 and $P_X(x_2)$ = 0 or vice-versa).

In an embodiment, the possible outcomes comprises at least one of: a binary value assigned to a pixel of the image 402, a first value being indicative of presence of a pattern within the image 402 and a second value being indicative of absence a pattern within the image 402; a grey scale value assigned to a pixel of the image 402; or number of colors assigned to pixels of the image 402.

In an embodiment, the entropy can be calculated for each channel and the entropy for each channel can be compared for selection of patterns. In an embodiment, the multi-channel image can be a collection of SEM images at the same location but with different SEM settings. The information metric per channel can be computed. The metric can be combined as a weighted average over all channels, or selected as a worst case of the metric among different channels.

In an embodiment, determining the values of the metric includes generating information content data by applying the metric to one or more pixels of the image 402. In an embodiment, generating the information content data includes sliding a window of specified size across the image 402; and computing, for each sliding position, a value of the metric applied within the window. In an embodiment, a shape and a size of the sliding window can be adjustable. For example, the sliding window can be of a size of a smallest feature (e.g., spacing 4x5 pixels), a user defined size (e.g., 2x2 pixels), or other window sizes. In an embodiment, the window can be rectangular, square, circular, or other geometric shapes.

In an embodiment, the determining of the metric does not include simulating, one or more of the plurality of patterns 401, a process model associated with a patterning process, or simulating, using one or more of the plurality of patterns 401, a machine learning model associated with the patterning process. The metric can be directly applied to the target layout, a portion of the target layout or patterns therein. In an embodiment, the target layout can be provided in GDS format.

Process P405 includes selecting, based on the metric, a sub-set of the plurality of patterns 401 from the one or more portions of the image 402 having values of the metric within a specified range. In an embodiment, the selecting the sub-set of patterns 410 includes comparing values of the metric across the image 402; identifying portions of the image 402 corresponding to values of the metric within the specified range; and selecting the sub-set of patterns 410 within the identified portions. For example, as shown in Figure 3D, the portion P1 of the target layout 300 corresponds to the metric being within the specified range. For example, the metric can be entropy and the specified range correspond to 10% of lowest values within the entropy image 335.

In an embodiment, the selecting the sub-set of patterns 410 includes: identifying portions of the image 402 corresponding to relatively low information entropy values compared to other portions; and selecting the sub-set of patterns 410 within the identified portions.

In an embodiment, the sub-set of patterns 410 includes at least a portion of a pattern of the sub-set of patterns 410. For example, the sub-set of pattern may comprise an entire feature or a portion of a feature within the pattern. In an example, referring to Figure 3D, one or more patterns (e.g., comprising one or more of entire features or portions of the features) can be selected from portions P1 can be selected based on the entropy at portion 336 of the entropy image 335.

Process P407 includes providing the sub-set of patterns 410 as training data for training a model associated with a patterning process. The present disclosure is not limited to the use of the outputted sub-patterns. In an embodiment, the sub-set of patterns can be used to improve one or more aspects of the patterning process including but not limited to improving training of aerial image model, mask model, resist model, OPC process, metrology related models or other models related to patterning process.

In an embodiment, the method 400 may further include steps for training, using the sub-set of patterns 410 as training data, a model associated with the patterning process. In an embodiment, the training includes training a model configured to generate optical proximity correction structures associated with the plurality of patterns 401 of a design layout. For example, the optical proximity correction structures includes main features corresponding to the plurality of patterns 401 of the design layout; or assist features surrounding the plurality of patterns 401 of the design layout.

In an embodiment, the method 400 for selecting patterns and generating training data therefrom can be implemented as follows. In an embodiment, the method includes obtaining an image 402 comprising a first pattern and a second pattern (e.g., patterns 401); determining, based on pixel intensities of the first pattern, a first level of informational entropy in a first portion of the image; determining, based on pixel intensities of the second pattern, a second level of informational entropy in a second portion of the image; comparing the first level of informational entropy and the second level of informational entropy; determining that the first level of informational entropy is lower than the second level of informational entropy based on the comparison; and in response to determining that the first level of informational entropy is lower than the second level of informational entropy, generating a training data set comprising the first pattern or at least a portion of the first pattern. For example, referring to Figure 3A, the first pattern can be selected from portions P1 based on the entropy of patterns around portion 336 of the entropy image 335.

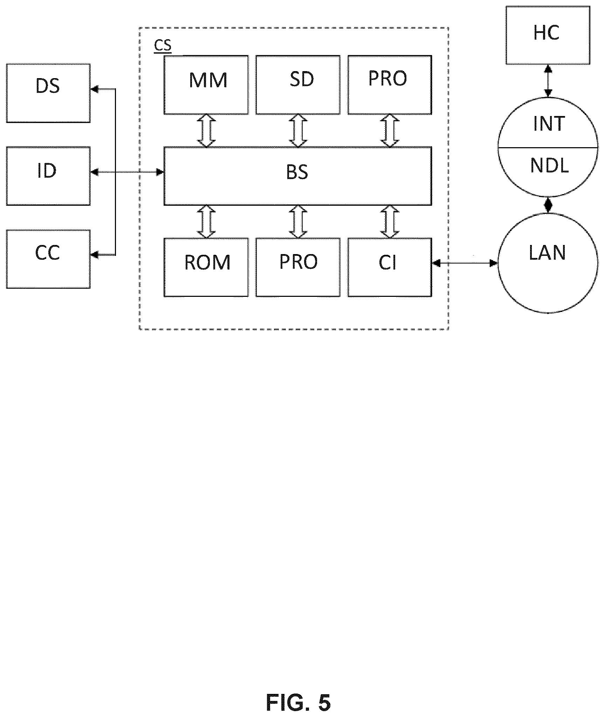

In an embodiment, the methods discussed herein may be provided as a computer program product or a non-transitory computer readable medium having instructions recorded thereon, the instructions when executed by a computer implementing the operation of the method 400 discussed above. For example, an example computer system CS in Figure 5 includes a non-transitory computer-readable media (e.g., memory) comprising instructions that, when executed by one or more processors (e.g., 104), cause operations for selecting patterns from a target layout. In an embodiment, the instructions including obtaining an image having a plurality of patterns; determining, based on pixel intensities within the image, a metric indicative of an amount of information contained in one or more portions of the image; selecting, based on the metric, a sub-set of the plurality of patterns from the one or more portions of the image having values of the metric within a specified range; and providing the sub-set of patterns as training data for training a model associated with a patterning process. In an embodiment, the amount of information is indicative of non-homogeneity of each of the plurality of patterns, an uncertainty associated with a model prediction obtained using the plurality of patterns, or an error associated with a model prediction obtained using the plurality of patterns. For example, the metric may be an entropy.

In an embodiment, the non-transitory medium is configured to the determining the values of the metric by generating information content data by applying the metric to one or more pixels of the image. In an embodiment, the generating the information content data includes sliding a window of specified size through the image; and computing, for each sliding position, a value of the metric applied within the window.

In an embodiment, a non-transitory computer-readable medium for generating training data sets for machine learning models based on levels of informational entropy in an image comprising instructions stored therein that, when executed by one or more processors, cause operations comprising: obtaining an image comprising a first pattern and a second pattern; determining, based on pixel intensities of the first pattern, a first level of informational entropy in a first portion of the image; determining, based on pixel intensities of the second pattern, a second level of informational entropy in a second portion of the image; comparing the first level of informational entropy and the second level of informational entropy; determining that the first level of informational entropy is lower than the second level of informational entropy based on the comparison; and in response to determining that the first level of informational entropy is lower than the second level of informational entropy, generating a training data set comprising the first pattern or at least a portion of the first pattern.

According to present disclosure, the combination and sub-combinations of disclosed elements constitute separate embodiments. For example, a first combination includes determining a metric indicative of information within an image and selecting patterns from the image based on the metric. The sub-combination may include determining an information entropy (e.g., using the entropy equation discussed above) of a portion of an image by a sliding window a small across the image. In another combination, the selected pattern can be employed in an inspection process, training a machine learning model related to a patterning process, determining OPC, or SMO using the selected pattern.

Figure 5 is a block diagram of an example computer system CS, according to an embodiment.

Computer system CS includes a bus BS or other communication mechanism for communicating information, and a processor PRO (or multiple processor) coupled with bus BS for processing information. Computer system CS also includes a main memory MM, such as a random access memory (RAM) or other dynamic storage device, coupled to bus BS for storing information and instructions to be executed by processor PRO. Main memory MM also may be used for storing temporary variables or other intermediate information during execution of instructions to be executed by processor PRO. Computer system CS further includes a read only memory (ROM) ROM or other static storage device coupled to bus BS for storing static information and instructions for processor PRO. A storage device SD, such as a magnetic disk or optical disk, is provided and coupled to bus BS for storing information and instructions.

Computer system CS may be coupled via bus BS to a display DS, such as a cathode ray tube (CRT) or flat panel or touch panel display for displaying information to a computer user. An input device ID, including alphanumeric and other keys, is coupled to bus BS for communicating information and command selections to processor PRO. Another type of user input device is cursor control CC, such as a mouse, a trackball, or cursor direction keys for communicating direction information and command selections to processor PRO and for controlling cursor movement on display DS. This input device typically has two degrees of freedom in two axes, a first axis (e.g., x) and a second axis (e.g., y), that allows the device to specify positions in a plane. A touch panel (screen) display may also be used as an input device.

According to one embodiment, portions of one or more methods described herein may be performed by computer system CS in response to processor PRO executing one or more sequences of one or more instructions contained in main memory MM. Such instructions may be read into main memory MM from another computer-readable medium, such as storage device SD. Execution of the sequences of instructions contained in main memory MM causes processor PRO to perform the process steps described herein. One or more processors in a multi-processing arrangement may also be employed to execute the sequences of instructions contained in main memory MM. In an alternative embodiment, hard-wired circuitry may be used in place of or in combination with software instructions. Thus, the description herein is not limited to any specific combination of hardware circuitry and software.

The term "computer-readable medium" as used herein refers to any medium that participates in providing instructions to processor PRO for execution. Such a medium may take many forms, including but not limited to, non-volatile media, volatile media, and transmission media. Non-volatile media include, for example, optical or magnetic disks, such as storage device SD. Volatile media include dynamic memory, such as main memory MM. Transmission media include coaxial cables, copper wire and fiber optics, including the wires that comprise bus BS. Transmission media can also take the form of acoustic or light waves, such as those generated during radio frequency (RF) and infrared (IR) data communications. Computer-readable media can be non-transitory, for example, a floppy disk, a flexible disk, hard disk, magnetic tape, any other magnetic medium, a CD-ROM, DVD, any other optical medium, punch cards, paper tape, any other physical medium with patterns of holes, a RAM, a PROM, and EPROM, a FLASH-EPROM, any other memory chip or cartridge. Non-transitory computer readable media can have instructions recorded thereon. The instructions, when executed by a computer, can implement any of the features described herein. Transitory computer-readable media can include a carrier wave or other propagating electromagnetic signal.

Various forms of computer readable media may be involved in carrying one or more sequences of one or more instructions to processor PRO for execution. For example, the instructions may initially be borne on a magnetic disk of a remote computer. The remote computer can load the instructions into its dynamic memory and send the instructions over a telephone line using a modem. A modem local to computer system CS can receive the data on the telephone line and use an infrared transmitter to convert the data to an infrared signal. An infrared detector coupled to bus BS can receive the data carried in the infrared signal and place the data on bus BS. Bus BS carries the data to main memory MM, from which processor PRO retrieves and executes the instructions. The instructions received by main memory MM may optionally be stored on storage device SD either before or after execution by processor PRO.

Computer system CS may also include a communication interface CI coupled to bus BS. Communication interface CI provides a two-way data communication coupling to a network link NDL that is connected to a local network LAN. For example, communication interface CI may be an integrated services digital network (ISDN) card or a modem to provide a data communication connection to a corresponding type of telephone line. As another example, communication interface CI may be a local area network (LAN) card to provide a data communication connection to a compatible LAN. Wireless links may also be implemented. In any such implementation, communication interface CI sends and receives electrical, electromagnetic or optical signals that carry digital data streams representing various types of information.

Network link NDL typically provides data communication through one or more networks to other data devices. For example, network link NDL may provide a connection through local network LAN to a host computer HC. This can include data communication services provided through the worldwide packet data communication network, now commonly referred to as the "Internet" INT. Local network LAN (Internet) both use electrical, electromagnetic or optical signals that carry digital data streams. The signals through the various networks and the signals on network data link NDL and through communication interface CI, which carry the digital data to and from computer system CS, are exemplary forms of carrier waves transporting the information.

Computer system CS can send messages and receive data, including program code, through the network(s), network data link NDL, and communication interface CI. In the Internet example, host computer HC might transmit a requested code for an application program through Internet INT, network data link NDL, local network LAN and communication interface CI. One such downloaded application may provide all or part of a method described herein, for example. The received code may be executed by processor PRO as it is received, and/or stored in storage device SD, or other non-volatile storage for later execution. In this manner, computer system CS may obtain application code in the form of a carrier wave.

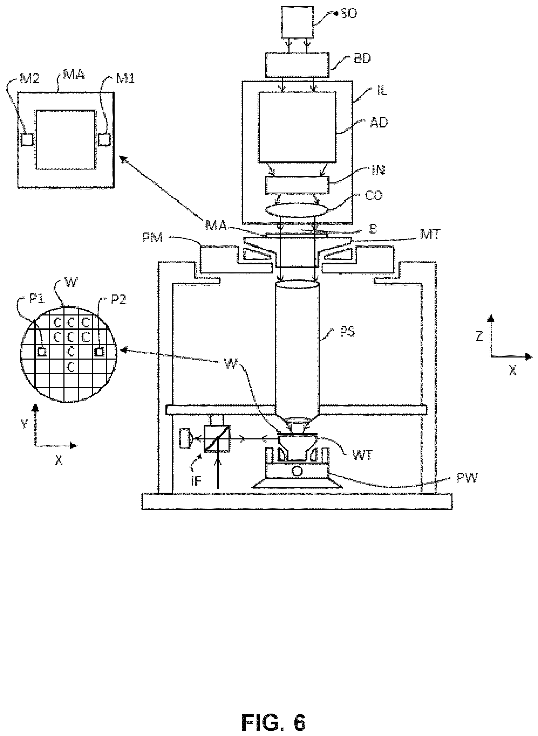

Figure 6 is a schematic diagram of a lithographic projection apparatus, according to an embodiment.

The lithographic projection apparatus can include an illumination system IL, a first object table MT, a second object table WT, and a projection system PS.

Illumination system IL, can condition a beam B of radiation. In this particular case, the illumination system also comprises a radiation source SO.

First object table (e.g., patterning device table) MT can be provided with a patterning device holder to hold a patterning device MA (e.g., a reticle), and connected to a first positioner to accurately position the patterning device with respect to item PS.

Second object table (substrate table) WT can be provided with a substrate holder to hold a substrate W (e.g., a resist-coated silicon wafer), and connected to a second positioner to accurately position the substrate with respect to item PS.

Projection system ("lens") PS (e.g., a refractive, catoptric or catadioptric optical system) can image an irradiated portion of the patterning device MA onto a target portion C (e.g., comprising one or more dies) of the substrate W.

As depicted herein, the apparatus can be of a transmissive type (i.e., has a transmissive patterning device). However, in general, it may also be of a reflective type, for example (with a reflective patterning device). The apparatus may employ a different kind of patterning device to classic mask; examples include a programmable mirror array or LCD matrix.

The source SO (e.g., a mercury lamp or excimer laser, LPP (laser produced plasma) EUV source) produces a beam of radiation. This beam is fed into an illumination system (illuminator) IL, either directly or after having traversed conditioning means, such as a beam expander Ex, for example. The illuminator IL may comprise adjusting means AD for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam B impinging on the patterning device MA has a desired uniformity and intensity distribution in its cross-section.

In some embodiments, source SO may be within the housing of the lithographic projection apparatus (as is often the case when source SO is a mercury lamp, for example), but that it may also be remote from the lithographic projection apparatus, the radiation beam that it produces being led into the apparatus (e.g., with the aid of suitable directing mirrors); this latter scenario can be the case when source SO is an excimer laser (e.g., based on KrF, ArF or F2 lasing).

The beam PB can subsequently intercept patterning device MA, which is held on a patterning device table MT. Having traversed patterning device MA, the beam B can pass through the lens PL, which focuses beam B onto target portion C of substrate W. With the aid of the second positioning means (and interferometric measuring means IF), the substrate table WT can be moved accurately, e.g. so as to position different target portions C in the path of beam PB. Similarly, the first positioning means can be used to accurately position patterning device MA with respect to the path of beam B, e.g., after mechanical retrieval of the patterning device MA from a patterning device library, or during a scan. In general, movement of the object tables MT, WT can be realized with the aid of a long-stroke module (coarse positioning) and a short-stroke module (fine positioning). However, in the case of a stepper (as opposed to a step-and-scan tool) patterning device table MT may just be connected to a short stroke actuator, or may be fixed.

The depicted tool can be used in two different modes, step mode and scan mode. In step mode, patterning device table MT is kept essentially stationary, and an entire patterning device image is projected in one go (i.e., a single "flash") onto a target portion C. Substrate table WT can be shifted in the x and/or y directions so that a different target portion C can be irradiated by beam PB.

In scan mode, essentially the same scenario applies, except that a given target portion C is not exposed in a single "flash." Instead, patterning device table MT is movable in a given direction (the so-called "scan direction", e.g., the y direction) with a speed v, so that projection beam B is caused to scan over a patterning device image; concurrently, substrate table WT is simultaneously moved in the same or opposite direction at a speed $V = Mv$, in which M is the magnification of the lens PL (typically, M = 1/4 or 1/5). In this manner, a relatively large target portion C can be exposed, without having to compromise on resolution.

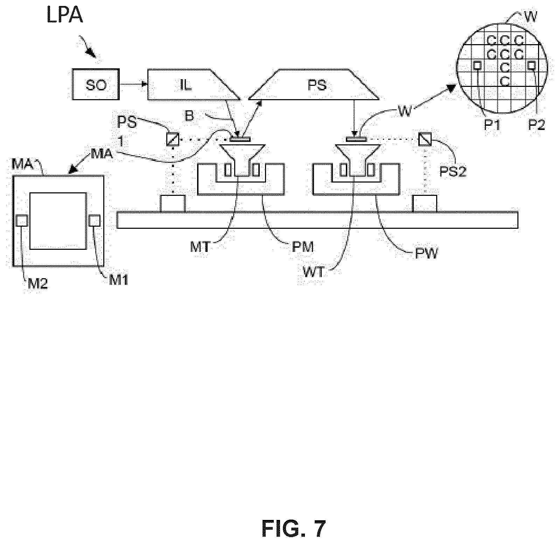

Figure 7 is a schematic diagram of another lithographic projection apparatus (LPA), according to an embodiment.

LPA can include source collector module SO, illumination system (illuminator) IL configured to condition a radiation beam B (e.g. EUV radiation), support structure MT, substrate table WT, and projection system PS.

Support structure (e.g. a patterning device table) MT can be constructed to support a patterning device (e.g. a mask or a reticle) MA and connected to a first positioner PM configured to accurately position the patterning device;

Substrate table (e.g. a wafer table) WT can be constructed to hold a substrate (e.g. a resist coated wafer) W and connected to a second positioner PW configured to accurately position the substrate.

Projection system (e.g. a reflective projection system) PS can be configured to project a pattern imparted to the radiation beam B by patterning device MA onto a target portion C (e.g. comprising one or more dies) of the substrate W.

As here depicted, LPA can be of a reflective type (e.g. employing a reflective patterning device). It is to be noted that because most materials are absorptive within the EUV wavelength range, the patterning device may have multilayer reflectors comprising, for example, a multi-stack of molybdenum and silicon. In one example, the multi-stack reflector has a 40 layer pairs of molybdenum and silicon where the thickness of each layer is a quarter wavelength. Even smaller wavelengths may be produced with X-ray lithography. Since most material is absorptive at EUV and x-ray wavelengths, a thin piece of patterned absorbing material on the patterning device topography (e.g., a TaN absorber on top of the multi-layer reflector) defines where features would print (positive resist) or not print (negative resist).

Illuminator IL can receive an extreme ultra violet radiation beam from source collector module SO. Methods to produce EUV radiation include, but are not necessarily limited to, converting a material into a plasma state that has at least one element, e.g., xenon, lithium or tin, with one or more emission lines in the EUV range. In one such method, often termed laser produced plasma ("LPP") the plasma can be produced by irradiating a fuel, such as a droplet, stream or cluster of material having the line-emitting element, with a laser beam. Source collector module SO may be part of an EUV radiation system including a laser, not shown in Figure 7, for providing the laser beam exciting the fuel. The resulting plasma emits output radiation, e.g., EUV radiation, which is collected using a radiation collector, disposed in the source collector module. The laser and the source collector module may be separate entities, for example when a $CO_2$ laser is used to provide the laser beam for fuel excitation.

In such cases, the laser may not be considered to form part of the lithographic apparatus and the radiation beam can be passed from the laser to the source collector module with the aid of a beam delivery system comprising, for example, suitable directing mirrors and/or a beam expander. In other cases, the source may be an integral part of the source collector module, for example when the source is a discharge produced plasma EUV generator, often termed as a DPP source.

Illuminator IL may comprise an adjuster for adjusting the angular intensity distribution of the radiation beam. Generally, at least the outer and/or inner radial extent (commonly referred to as $\sigma$-outer and $\sigma$-inner, respectively) of the intensity distribution in a pupil plane of the illuminator can be adjusted. In addition, the illuminator IL may comprise various other components, such as facetted field and pupil mirror devices. The illuminator may be used to condition the radiation beam, to have a desired uniformity and intensity distribution in its cross section.

The radiation beam B can be incident on the patterning device (e.g., mask) MA, which is held on the support structure (e.g., patterning device table) MT, and is patterned by the patterning device. After being reflected from the patterning device (e.g. mask) MA, the radiation beam B passes through the projection system PS, which focuses the beam onto a target portion C of the substrate W. With the aid of the second positioner PW and position sensor PS2 (e.g. an interferometric device, linear encoder or capacitive sensor), the substrate table WT can be moved accurately, e.g. so as to position different target portions C in the path of radiation beam B. Similarly, the first positioner PM and another position sensor PS1 can be used to accurately position the patterning device (e.g. mask) MA with respect to the path of the radiation beam B. Patterning device (e.g. mask) MA and substrate W may be aligned using patterning device alignment marks M1, M2 and substrate alignment marks P1, P2.

The depicted apparatus LPA could be used in at least one of the following modes, step mode, scan mode, and stationary mode.

In step mode, the support structure (e.g. patterning device table) MT and the substrate table WT are kept essentially stationary, while an entire pattern imparted to the radiation beam is projected onto a target portion C at one time (i.e. a single static exposure). The substrate table WT is then shifted in the X and/or Y direction so that a different target portion C can be exposed.

In scan mode, the support structure (e.g. patterning device table) MT and the substrate table WT are scanned synchronously while a pattern imparted to the radiation beam is projected onto target portion C (i.e. a single dynamic exposure). The velocity and direction of substrate table WT relative to the support structure (e.g. patterning device table) MT may be determined by the (de-)magnification and image reversal characteristics of the projection system PS.

In stationary mode, the support structure (e.g. patterning device table) MT is kept essentially stationary holding a programmable patterning device, and substrate table WT is moved or scanned while a pattern imparted to the radiation beam is projected onto a target portion C. In this mode, generally a pulsed radiation source is employed and the programmable patterning device is updated as required after each movement of the substrate table WT or in between successive radiation pulses during a scan. This mode of operation can be readily applied to maskless lithography that utilizes programmable patterning device, such as a programmable mirror array of a type as referred to above.

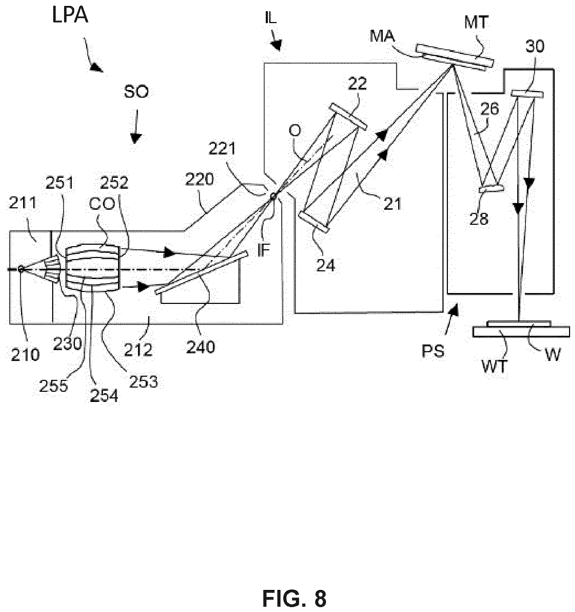

Figure 8 is a detailed view of the lithographic projection apparatus, according to an embodiment.

As shown, LPA can include the source collector module SO, the illumination system IL, and the projection system PS. The source collector module SO is constructed and arranged such that a vacuum environment can be maintained in an enclosing structure 220 of the source collector module SO. An EUV radiation emitting plasma 210 may be formed by a discharge produced plasma source. EUV radiation may be produced by a gas or vapor, for example Xe gas, Li vapor or Sn vapor in which the very hot plasma 210 is created to emit radiation in the EUV range of the electromagnetic spectrum. The very hot plasma 210 is created by, for example, an electrical discharge causing at least partially ionized plasma. Partial pressures of, for example, 10 Pa of Xe, Li, Sn vapor or any other suitable gas or vapor may be required for efficient generation of the radiation. In an embodiment, a plasma of excited tin (Sn) is provided to produce EUV radiation.

The radiation emitted by the hot plasma 210 is passed from a source chamber 211 into a collector chamber 212 via an optional gas barrier or contaminant trap 230 (in some cases also referred to as contaminant barrier or foil trap) which is positioned in or behind an opening in source chamber 211. The contaminant trap 230 may include a channel structure. Contamination trap 230 may also include a gas barrier or a combination of a gas barrier and a channel structure. The contaminant trap or contaminant barrier 230 further indicated herein at least includes a channel structure, as known in the art.

The collector chamber 211 may include a radiation collector CO which may be a so-called grazing incidence collector. Radiation collector CO has an upstream radiation collector side 251 and a downstream radiation collector side 252. Radiation that traverses collector CO can be reflected off a grating spectral filter 240 to be focused in a virtual source point IF along the optical axis indicated by the dot-dashed line 'O'. The virtual source point IF is commonly referred to as the intermediate focus, and the source collector module is arranged such that the intermediate focus IF is located at or near an opening 221 in the enclosing structure 220. The virtual source point IF is an image of the radiation emitting plasma 210.

Subsequently the radiation traverses the illumination system IL, which may include a facetted field mirror device 22 and a facetted pupil mirror device 24 arranged to provide a desired angular distribution of the radiation beam 21, at the patterning device MA, as well as a desired uniformity of radiation intensity at the patterning device MA. Upon reflection of the beam of radiation 21 at the patterning device MA, held by the support structure MT, a patterned beam 26 is formed and the patterned beam 26 is imaged by the projection system PS via reflective elements 28, 30 onto a substrate W held by the substrate table WT.

More elements than shown may generally be present in illumination optics unit IL and projection system PS. The grating spectral filter 240 may optionally be present, depending upon the type of lithographic apparatus. Further, there may be more mirrors present than those shown in the figures, for example there may be 1- 6 additional reflective elements present in the projection system PS than shown in Figure 8.

Collector optic CO, as illustrated in Figure 8, is depicted as a nested collector with grazing incidence reflectors 253, 254 and 255, just as an example of a collector (or collector mirror). The grazing incidence reflectors 253, 254 and 255 are disposed axially symmetric around the optical axis O and a collector optic CO of this type may be used in combination with a discharge produced plasma source, often called a DPP source.

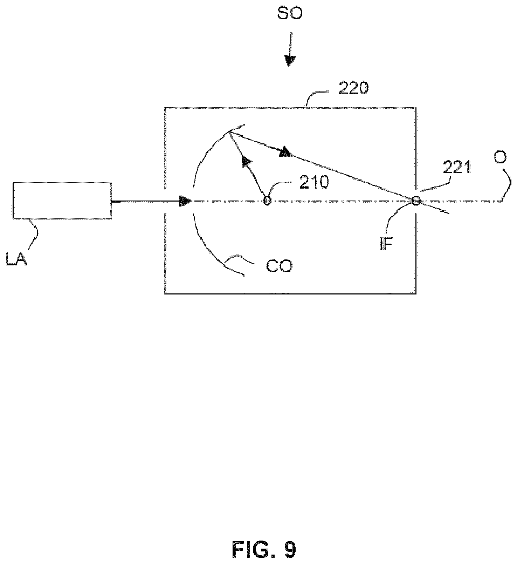

Figure 9 is a detailed view of source collector module SO of lithographic projection apparatus LPA, according to an embodiment.

Source collector module SO may be part of an LPA radiation system. A laser LA can be arranged to deposit laser energy into a fuel, such as xenon (Xe), tin (Sn) or lithium (Li), creating the highly ionized plasma 210 with electron temperatures of several 10's of eV. The energetic radiation generated during de-excitation and recombination of these ions is emitted from the plasma, collected by a near normal incidence collector optic CO and focused onto the opening 221 in the enclosing structure 220.

The concepts disclosed herein may simulate or mathematically model any generic imaging system for imaging sub wavelength features, and may be especially useful with emerging imaging technologies capable of producing increasingly shorter wavelengths. Emerging technologies already in use include EUV (extreme ultra violet), DUV lithography that is capable of producing a 193nm wavelength with the use of an ArF laser, and even a 157nm wavelength with the use of a Fluorine laser. Moreover, EUV lithography is capable of producing wavelengths within a range of 20-50nm by using a synchrotron or by hitting a material (either solid or a plasma) with high energy electrons in order to produce photons within this range.

Embodiments of the present disclosure can further be described by the following clauses:

1. A non-transitory computer-readable medium for generating training data sets for machine learning models based on levels of informational entropy in an image comprising instructions stored therein that, when executed by one or more processors, cause operations comprising:

obtaining an image comprising a first pattern and a second pattern;
determining, based on pixel intensities of the first pattern, a first level of informational entropy in a first portion of the image;
determining, based on pixel intensities of the second pattern, a second level of informational entropy in a second portion of the image;
comparing the first level of informational entropy and the second level of informational entropy;

determining that the first level of informational entropy is lower than the second level of informational entropy based on the comparison; and

in response to determining that the first level of informational entropy is lower than the second level of informational entropy, generating a training data set comprising the first pattern or at least a portion of the first pattern.

2. A non-transitory computer-readable medium comprising instructions stored therein that, when executed by one or more processors, cause operations comprising:

obtaining an image having a plurality of patterns;

determining, based on pixel intensities within the image, a metric indicative of an amount of information contained in one or more portions of the image;

selecting, based on the metric, a sub-set of the plurality of patterns from the one or more portions of the image having values of the metric within a specified range; and

providing the sub-set of patterns as training data for training a model associated with a patterning process.

3. The medium of clause 2, wherein the amount of information is indicative of non-homogeneity of each of the plurality of patterns, an uncertainty associated with a model prediction obtained using the plurality of patterns, or an error associated with a model prediction obtained using the plurality of patterns.

4. The medium of clauses 2-3, the determining the values of the metric comprises:

generating information content data by applying the metric to one or more pixels of the image.

5. The medium of clause 4, wherein the generating the information content data comprises:

sliding a window of specified shape and/or size through the image; and

computing, for each sliding position, a value of the metric applied within the window.

6. The medium of any of clauses 2-5, wherein the metric is at least one of an information entropy, Renyi entropy, or differential entropy.

7. The medium of clause 6, wherein the information entropy comprises a sum of products of a probability of an outcome of a plurality of possible outcomes associated with the image and a logarithmic function of the probability of the outcome.

8. The medium of clause 7, wherein the possible outcomes comprises at least one of:

a binary value assigned to a pixel of the image, a first value being indicative of presence of a pattern within the image and a second value being indicative of absence a pattern within the image; or

a grey scale value assigned to a pixel of the image.

9. The medium of any of clauses 2-8, wherein determining the metric does not include:

simulating, one or more of the plurality of patterns, a process model associated with a patterning process, or

simulating, using one or more of the plurality of patterns, a machine learning model associated with the patterning process.

10. The medium of any of clauses 2-9, wherein the selecting the sub-set of patterns comprises:

comparing values of the metric across the image;

identifying portions of the image corresponding to values of the metric within the specified range; and

selecting the sub-set of patterns within the identified portions.

11. The medium of any of clauses 6-8, wherein the selecting the sub-set of patterns comprises:

identifying portions of the image corresponding to relatively low information entropy values compared to other portions; and

selecting the sub-set of patterns within the identified portions.

12. The medium of any of clauses 2-11, wherein the sub-set of patterns comprises: at least a portion of a pattern of the sub-set of patterns.

13. The medium of any of clauses 2-12, wherein the image is at least one of:

a design layout comprising patterns to be printed on a substrate; or
a SEM image of a patterned substrate acquired via a scanning electron microscope (SEM).

14. The medium of any of clauses 2-13, wherein the image is at least one of:

a binary image,
a grey scale image; or
a n-channel image, wherein n refers to number of colors used in the image.

15. The medium of any of clauses 2-14, further cause operations comprising:
training, using the sub-set of patterns as training data, a model associated with the patterning process.
16. The medium of clause 15, wherein the training comprises:
training a model configured to generate optical proximity correction structures associated with the plurality of patterns of a design layout.
17. The medium of clause 16, wherein the optical proximity correction structures comprises:

main features corresponding to the plurality of patterns of the design layout; or
assist features surrounding the plurality of patterns of the design layout.

18. A non-transitory computer-readable medium storing instructions for training a model based on training data, when executed by one or more processors, the training data being produced by:

obtaining an image having a plurality of patterns;
determining, based on pixel intensities within the image, a metric indicative of an amount of information contained in one or more portions of the image;
selecting, based on the metric, a sub-set of the plurality of patterns from the one or more portions of the image having values of the metric within a specified range; and
providing the sub-set of patterns as training data for training a model associated with a patterning process.

19. The medium of clause 18, wherein the amount of information is indicative of non-homogeneity of each of the plurality of patterns, an uncertainty associated with a model prediction obtained using the plurality of patterns, or an error associated with a model prediction obtained using the plurality of patterns.
20. The medium of clause 18, wherein the determining values of the metric comprises:

sliding a window of specified shape and/ or size through the image; and
computing, for each sliding position, a value of the metric applied within the window.

21. The medium of any of clauses 18-20, wherein the metric is at least one of an information entropy, Renyi entropy, or differential entropy.
22. The medium of clause 21, wherein the information entropy comprises a sum of products of a probability of an outcome of a plurality of possible outcomes associated with the image and a logarithmic function of the probability of the outcome.
23. The medium of clause 22, wherein the possible outcomes comprises at least one of:

a binary value assigned to a pixel of the image, a first value being indicative of presence of a pattern within the image and a second value being indicative of absence a pattern within the image; or
a grey scale value assigned to a pixel of the image.

24. The medium of any of clauses 18-23, wherein determining the metric does not include:

simulating, one or more of the plurality of patterns, a process model associated with a patterning process, or
simulating, using one or more of the plurality of patterns, a machine learning model associated with the patterning process.

25. The medium of any of clauses 18-24, wherein the selecting the sub-set of patterns comprises:

comparing values of the metric across the image;
identifying portions of the image corresponding to values of the metric within the specified range; and

selecting the sub-set of patterns within the identified portions.

26. The medium of any of clauses 21-24, wherein the selecting the sub-set of patterns comprises:

identifying portions of the image corresponding to relatively low information entropy values compared to other portions; and
selecting the sub-set of patterns within the identified portions.

27. The medium of any of clauses 18-26, wherein the sub-set of patterns comprises: at least a portion of a pattern of the sub-set of patterns.

28. The medium of any of clauses 18-27, wherein the image is at least one of:

a design layout comprising patterns to be printed on a substrate; or
a SEM image of a patterned substrate acquired via a scanning electron microscope (SEM).

29. The medium of any of clauses 18-28, wherein the image is at least one of:

a binary image,
a grey scale image; or
a n-channel image, wherein n refers to number of colors used in the image.

30. A method for generating training data for training a model, the method comprising:

obtaining an image having a plurality of patterns;
determining, based on pixel intensities within the image, a metric indicative of an amount of information contained in one or more portions of the image;
selecting, based on the metric, a sub-set of the plurality of patterns from the one or more portions of the image having values of the metric within a specified range; and
providing the sub-set of patterns as training data for training a model associated with a patterning process.

31. The method of clause 30, wherein the amount of information is indicative of non-homogeneity of each of the plurality of patterns, an uncertainty associated with a model prediction obtained using the plurality of patterns, or an error associated with a model prediction obtained using the plurality of patterns.

32. The method of clauses 30-31, the determining the values of the metric comprises:
generating information content data by applying the metric to one or more pixels of the image.

33. The method of clause 32, wherein the generating the information content data comprises:

sliding a window of specified shape and/or size through the image; and
computing, for each sliding position, a value of the metric applied within the window.

34. The method of any of clauses 30-33, wherein the metric is at least one of an information entropy, Renyi entropy, or differential entropy.

35. The method of clause 34, wherein the information entropy comprises a sum of products of a probability of an outcome of a plurality of possible outcomes associated with the image and a logarithmic function of the probability of the outcome.

36. The method of clause 35, wherein the possible outcomes comprises at least one of:

a binary value assigned to a pixel of the image, a first value being indicative of presence of a pattern within the image and a second value being indicative of absence a pattern within the image; or
a grey scale value assigned to a pixel of the image.

37. The method of any of clauses 30-36, wherein determining the metric does not include:

simulating, one or more of the plurality of patterns, a process model associated with a patterning process, or
simulating, using one or more of the plurality of patterns, a machine learning model associated with the patterning process.

38. The method of any of clauses 30-37, wherein the selecting the sub-set of patterns comprises:

comparing values of the metric across the image;
identifying portions of the image corresponding to values of the metric within the specified range; and
selecting the sub-set of patterns within the identified portions.

39. The method of any of clauses 34-37, wherein the selecting the sub-set of patterns comprises:

identifying portions of the image corresponding to relatively low information entropy values compared to other portions; and
selecting the sub-set of patterns within the identified portions.

40. The method of any of clauses 30-39, wherein the sub-set of patterns comprises: at least a portion of a pattern of the sub-set of patterns.

41. The method of any of clauses 30-40, wherein the image is at least one of:

a design layout comprising patterns to be printed on a substrate; or
a SEM image of a patterned substrate acquired via a scanning electron microscope (SEM).

42. The method of any of clauses 30-41, wherein the image is at least one of:

a binary image,
a grey scale image; or
a n-channel image, wherein n refers to number of colors used in the image.

43. The method of any of clauses 30-42, further cause operations comprising:
training, using the sub-set of patterns as training data, a model associated with the patterning process.

44. The method of clause 43, wherein the training comprises:
training a model configured to generate optical proximity correction structures associated with the plurality of patterns of a design layout.

45. The method of clause 44, wherein the optical proximity correction structures comprises:

main features corresponding to the plurality of patterns of the design layout; or
assist features surrounding the plurality of patterns of the design layout.

While the concepts disclosed herein may be used for imaging on a substrate such as a silicon wafer, it shall be understood that the disclosed concepts may be used with any type of lithographic imaging systems, e.g., those used for imaging on substrates other than silicon wafers.

The descriptions herein are intended to be illustrative, not limiting. Thus, it will be apparent to one skilled in the art that modifications may be made as described without departing from the scope of the claims set out below.

**Claims**

1.  A non-transitory computer-readable medium comprising instructions stored therein that, when executed by one or more processors, cause operations comprising:

    obtaining an image having a plurality of patterns;
    determining, based on pixel intensities within the image, a metric indicative of an amount of information contained in one or more portions of the image;
    selecting, based on the metric, a sub-set of the plurality of patterns from the one or more portions of the image having values of the metric within a specified range; and
    providing the sub-set of patterns as training data for training a model associated with a patterning process.

2.  The medium of claim 2, wherein the amount of information corresponds to non-homogeneity of each of the plurality of patterns, an uncertainty associated with a model prediction, or an error associated with a model prediction.

3.  The medium of claim 1, wherein the determining the metric comprises:
    generating information content data by applying the metric to one or more pixels of the image.

4. The medium of claim 3, wherein the generating the information content data comprises:

   sliding a window of specified shape and/or size through the image; and
   computing, for each sliding position, a value of the metric applied within the window.

5. The medium of claim 1, wherein the metric is at least one of an information entropy, Renyi entropy, or differential entropy.

6. The medium of claim 5, wherein the information entropy comprises a sum of products of a probability of an outcome of a plurality of possible outcomes associated with the image and a logarithmic function of the probability of the outcome.

7. The medium of claim 6, wherein the possible outcomes comprises at least one of:

   a binary value assigned to a pixel of the image, a first value being indicative of presence of a pattern within the image and a second value being indicative of absence a pattern within the image; or
   a grey scale value assigned to a pixel of the image.

8. The medium of claim 1, wherein determining the metric is performed without:

   simulating, one or more of the plurality of patterns, a process model associated with a patterning process, or
   simulating, using one or more of the plurality of patterns, a machine learning model associated with the patterning process.

9. The medium of claim 1, wherein the selecting the sub-set of patterns comprises:

   comparing values of the metric across the image;
   identifying portions of the image corresponding to values of the metric within the specified range; and
   selecting the sub-set of patterns within the identified portions.

10. The medium of claim 5, wherein the selecting the sub-set of patterns comprises:

    identifying portions of the image corresponding to relatively low information entropy values compared to other portions; and
    selecting the sub-set of patterns within the identified portions.

11. The medium of claim 1, wherein the sub-set of patterns comprises: at least a portion of a pattern of the sub-set of patterns.

12. The medium of claim 1, wherein the image is at least one of:

    a design layout comprising patterns to be printed on a substrate; or
    a SEM image of a patterned substrate acquired via a scanning electron microscope (SEM).

13. The medium of claim 1, wherein the image is at least one of:

    a binary image,
    a grey scale image; or
    a n-channel image, wherein n refers to number of colors used in the image.

14. The medium of claim 1, further cause operations comprising:
    training, using the sub-set of patterns as training data, a model associated with the patterning process.

15. The medium of claim 14, wherein the training comprises:
    training a model configured to generate optical proximity correction structures associated with the plurality of patterns of a design layout, wherein the optical proximity correction structures comprises one or more of:

    main features corresponding to the plurality of patterns of the design layout; or

assist features surrounding the plurality of patterns of the design layout.

FIG. 1

FIG. 2

FIG. 3A

EP 3 951 496 A1

FIG. 3B

FIG. 3C

FIG. 3D

pearsonr = -0.82; p = 0

entropy (target)

log(|error|)

FIG. 3E

pearsonr = -0.89; p = 0

entropy (target)

log(uncertainty)

FIG. 3F

400

402 ← 401

↓

P401

↓

P403

↓

P405

↓

P407

↓

410

FIG. 4

FIG. 5

**FIG. 6**

FIG. 7

FIG. 8

FIG. 9

Europäisches
Patentamt

European
Patent Office

Office européen
des brevets

# EUROPEAN SEARCH REPORT

**Application Number**

EP 20 18 9955

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>Y<br>A | WO 2019/162346 A1 (ASML NETHERLANDS BV [NL]) 29 August 2019 (2019-08-29)<br>* paragraph [0081]; figure 4 *<br>* paragraphs [0096] - [0124]; figure 8 *<br>* paragraph [0205] *<br>----- | 1-3,8,9,<br>11-15<br>4,5,10<br>6,7 | INV.<br>G03F1/36<br>G03F1/70<br>G03F7/20<br>G06F30/398<br>G06N20/00<br>G06T7/00 |
| Y | APARNA R ET AL: "Application of image intensity local variance measure for analysis of distorted images",<br>2017 INTERNATIONAL CONFERENCE ON NETWORKS & ADVANCES IN COMPUTATIONAL TECHNOLOGIES (NETACT), IEEE,<br>20 July 2017 (2017-07-20), pages 382-386,<br>XP033234009,<br>DOI: 10.1109/NETACT.2017.8076800<br>[retrieved on 2017-10-19]<br>* Sections II, III *<br>----- | 4,5,10 | |
| Y | YIN SHIBAI ET AL: "Unsupervised hierarchical image segmentation through fuzzy entropy maximization",<br>PATTERN RECOGNITION, ELSEVIER, GB,<br>vol. 68, 9 March 2017 (2017-03-09), pages 245-259, XP029983927,<br>ISSN: 0031-3203, DOI:<br>10.1016/J.PATCOG.2017.03.012<br>* Section I *<br>----- | 5,10 | **TECHNICAL FIELDS SEARCHED (IPC)**<br><br>G03F<br>G06F<br>G06T<br>G06N |

The present search report has been drawn up for all claims

| Place of search | Date of completion of the search | Examiner |
|---|---|---|
| Munich | 19 January 2021 | van Toledo, Wiebo |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 20 18 9955

This annex lists the patent family members relating to the patent documents cited in  the above-mentioned European search report.
The members are as contained in the European Patent Office EDP file on
The European Patent Office is in no way liable for these particulars which are merely given for the purpose of information.

19-01-2021

| Patent document cited in search report | Publication date | Patent family member(s) | Publication date |
|---|---|---|---|
| WO 2019162346 A1 | 29-08-2019 | CN 111788589 A<br>KR 20200113240 A<br>TW 201939365 A<br>US 2020380362 A1<br>WO 2019162346 A1 | 16-10-2020<br>06-10-2020<br>01-10-2019<br>03-12-2020<br>29-08-2019 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6046792 A
- US 5229872 A
- US 20090157630 A
- US 20080301620 A
- US 20070050749 A
- US 20070031745 A
- US 20080309897 A
- US 20100162197 A
- US 20100180251 A
- US 7587704 B